# EUROPEAN PATENT SPECIFICATION

(11) **EP 4 300 391 B1**
(45) Date of publication and mention of the grant of the patent: **16.09.2026**
(21) Application number: 23169395.3
(22) Date of filing: 24.04.2023
(51) Int. Cl.: G06Q 10/047, G06Q 10/0631, B66B 1/24, B66B 5/00

(54) **MOBILITY OPERATION EVALUATION SYSTEM, SIMULATION SYSTEM, AND MOBILITY OPERATION EVALUATION METHOD**
SYSTEM ZUR EVALUIERUNG EINES MOBILITÄTSVORGANGS, SIMULATIONSSYSTEM UND VERFAHREN ZUR EVALUIERUNG EINES MOBILITÄTSVORGANGS
SYSTÈME D'ÉVALUATION D'OPÉRATION DE MOBILITÉ, SYSTÈME DE SIMULATION ET PROCÉDÉ D'ÉVALUATION D'OPÉRATION DE MOBILITÉ

(30) Priority: 27.06.2022 JP 2022102528
(43) Date of publication of application: 03.01.2024
(73) Proprietor: Hitachi, Ltd., Tokyo 100-8280 (JP)
(72) Inventor: NING, Rui, Tokyo, 1008280 (JP); SUZUKI, Shintaro, Tokyo, 1008280 (JP); KATOU, Manabu, Tokyo, 101-8941 (JP)
(74) Representative: Mewburn Ellis LLP

(56) References cited:
- WO-A1-2018/211650
- US-A1- 2012 041 593
- US-A1- 2022 108 245

## Description

### Technical Field

The present invention relates to a mobility operation evaluation system, a simulation system, and a mobility operation evaluation method.

### Background Art

In order to improve productivity due to automation and compensate for a decrease in labor population, robots have been used. In buildings, the introduction of robots has also started for various purposes such as guidance and load transportation. When robots are introduced, it is necessary to evaluate an influence on operations of buildings in advance and set the deployment, number, movable ranges, and the like of the robots.

For example, Patent Literature 1 discloses a technique for evaluating movement in a building. Patent Literature 1 discloses a population flow calculation device that evaluates a mutual influence between operations of elevators and movement of passengers with regard to congestion of people using the elevators to move in a building.

### Citation List

### Patent Literature

Patent Literature 1: JP 2009-96612 A.

Further examples of prior art systems concerning coordination of autonomous mobile robots in buildings with elevators are disclosed in WO 2018/211650 A1, US 2012/041593 A1 and US 2022/108245 A1.

### Summary of Invention

### Technical Problem

However, in the population flow computation device disclosed in Patent Literature 1, only movement of people is considered, and movement of robots is not considered. Therefore, congestion statuses of elevators in the case of the introduction of robots cannot be evaluated.

In view of the above problems, an object of the present invention is to provide a mobility operation evaluation system, a simulation system, and a mobility operation evaluation method capable of evaluating congestion states of elevators in an environment in which there are movable objects other than people such as robots. Solution to Problem

In order to solve the above problems and achieve the present object, a mobility operation evaluation system according to an aspect of the present invention evaluates movement of a plurality of movable objects including a person and a mobility including an elevator in a building. The mobility operation evaluation system includes a movement model generation unit, a movement demand generation unit, a supervision control unit, a route generation unit, a movement simulation unit, an elevator simulation unit, an evaluation unit, and an output unit. The movement model generation unit generates a movement model defining a condition related to the movement of the plurality of movable objects. The movement demand generation unit calculates a movement demand of each movement model. The supervision control unit allocates the movement demand to each movement model. The route generation unit generates a movement route of each movement model based on the movement demand of each movement model. The movement simulation unit simulates movement of each movement model based on the movement route of each movement model. The elevator simulation unit simulates an operation of the elevator. The evaluation unit calculates evaluation values related to movement of the plurality of movement models in the building and the operation of the elevator from simulation results of the movement simulation unit and the elevator simulation unit. The output unit outputs the evaluation values calculated by the evaluation unit.

A mobility operation evaluation method according to another aspect of the present invention includes a model creation process, a movement demand generation process, an allocation process, a route generation process, a movement simulation process, an elevator simulation process, an evaluation calculation process, and an output process. In the model creation process, movement models of a plurality of movable objects are generated. In the movement demand generation process, a movement demand of each movement model is calculated. In the allocation process, a movement demand is allocated to each movement model. In the route generation process, the movement route of each movement model is generated based on the movement demand of each movement model. In the movement simulation process, movement of each movement model is simulated based on the movement route of each movement model. In the elevator simulation process, an operation of the elevator is simulated. In the evaluation calculation process, evaluation values related to movement of the plurality of movement models in the building and the operation of the elevator are calculated from simulation results of the movement simulation process and the elevator simulation process. In the output process, the evaluation value calculated in the evaluation calculation process is output.

### Advantageous Effects of Invention

According to the present invention, it is possible to evaluate the congestion status of the elevator in an environment in which there are movable objects other than people such as robots.

### Brief Description of Drawings

Fig. 1 is a block diagram illustrating a functional configuration of a mobility operation evaluation system according to a first embodiment.
Fig. 2 is a diagram illustrating an example of space structure data of the mobility operation evaluation system according to the first embodiment.
Fig. 3 is a diagram illustrating an example of movement demand data of the mobility operation evaluation system according to the first embodiment.
Fig. 4 is a diagram illustrating an example of elevator data of the mobility operation evaluation system according to the first embodiment.
Fig. 5 is a diagram illustrating an example of mobility information data of the mobility operation evaluation system according to the first embodiment.
Fig. 6 is a diagram illustrating an example of mobility type data of the mobility operation evaluation system according to the first embodiment.
Fig. 7 is a flowchart illustrating a mobility operation evaluation process of the mobility operation evaluation system according to the first embodiment.
Fig. 8 is a diagram illustrating a display example of a simulation result of the mobility operation evaluation system according to the first embodiment.
Fig. 9 is a flowchart illustrating a mobility agent movement process of the mobility operation evaluation system according to the first embodiment.
Fig. 10 is a block diagram illustrating a functional configuration of a mobility operation evaluation system according to a second embodiment.
Fig. 11 is a flowchart illustrating a mobility operation evaluation process of the mobility operation evaluation system according to the second embodiment.

### Description of Embodiments

Hereinafter, a mobility operation evaluation system, a simulation system, and a mobility operation evaluation method according to an embodiment will be described. In the drawings, common members are denoted by the same reference numerals.

### <First Embodiment>

### [Configuration of Mobility Operation Evaluation System]

First, a configuration of a mobility operation evaluation system according to a first embodiment will be described.

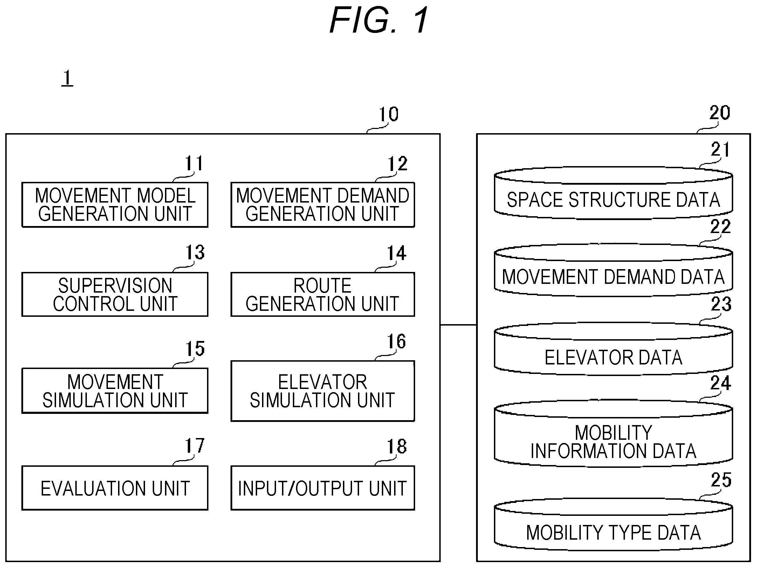

Fig. 1 is a block diagram illustrating a functional configuration of a mobility operation evaluation system according to the first embodiment.

The mobility operation evaluation system according to the first embodiment evaluates movement of a mobility such as an autonomous mobile robot in a virtual space by simulation.

The mobility operation evaluation system 1 according to the first embodiment includes a computer including an arithmetic device and a control device such as a CPU, a main recording device such as a DRAM or an SRAM, an auxiliary storage device such as an HDD or an SSD, an input device such as a mouse or a keyboard, an output device such as a display or a printer, a communication device that performs communication between devices, and software that operates on the computer.

As illustrated in Fig. 1, the mobility operation evaluation system 1 includes a processing unit 10 that performs calculation and the like, and a recording unit 20 that records data.

The processing unit 10 includes a movement model generation unit 11, a movement demand generation unit 12, a supervision control unit 13, a route generation unit 14, a movement simulation unit 15, an elevator simulation unit 16, an evaluation unit 17, and an input/output unit 18. These units are distinguished for facilitating description, and may actually be configured as the same software or may be divided in accordance with different methods.

The recording unit 20 stores space structure data 21, movement demand data 22, elevator data 23, mobility information data 24, mobility type data 25, and the like.

### (Movement Model Generation Unit)

The movement model generation unit 11 generates a movement model of a mobility or a person for performing simulation. The movement model generation unit 11 generates a movement model of mobility based on a basic attribute related to movement of a mobility. The basic attribute related to the movement of mobility is input by a user or is supplied in advance in the system.

Examples of the basic attribute include a movable direction, a movable area, a turning radius, the possibility of boarding an elevator, and an elevator boarding method (the possibility of riding along with another mobility or a person). A method of generating a movement model is not limited thereto. For example, a method of preparing several types of movement models as templates and selecting a movement model from the templates may be adopted.

### (Movement Demand Generation Unit)

The movement demand generation unit 12 generates a movement demand of a mobility or a person. The movement demand generation unit 12 refers to, for example, movement occurrence probability data provided for each movement destination candidate place of a mobility to determine whether movement to the movement destination candidate place occurs in each period of time. Then, when movement to the movement destination candidate place occurs, the movement demand generation unit 12 creates (generates) a movement demand to the movement destination candidate place.

The movement occurrence probability data is data in which a movement occurrence probability per number of people in the building at a location (a floor or a position) of a movement source is recorded in each period of time. The movement occurrence probability is determined, for example, based on past actual result data in a similar building.

### (Supervision Control Unit)

The supervision control unit 13 selects a mobility or a person to be moved based on the movement demand of the mobility or the person generated by the movement demand generation unit 12. The supervision control unit 13 evaluates a plurality of mobilities based on, for example, a distance between a point where a movement demand occurs and the mobility, a time in which a mobility task can be allocated, and the like. Then, the supervision control unit 13 selects the mobility with a high evaluation value as a mobility to be moved in accordance with the movement demand. The supervision control unit 13 gives an instruction for a movement command to the movement model of the mobility or the person.

### (Route Generation Unit)

The route generation unit 14 generates a movement route between a start point and an end point in accordance with a basic attribute of a movement model of a mobility and a person. The movement route is calculated by, for example, a known Dijkstra method.

### (Movement Simulation Unit)

The movement simulation unit 15 generates a virtual space based on space structure data 21 to be described below. Then, the movement simulation unit 15 moves a movable agent in the virtual space along the movement route, and performs a simulation that simulates a congestion status in the virtual space and an interaction between the movable objects. The movement simulation unit 15 outputs a result of the simulation to the input/output unit 18. The movement simulation unit 15 can be implemented, for example, by using a known multi-agent simulation technology.

The mobile agent simulates a mobile object in the simulation. The mobile agent includes a mobility agent corresponding to the movement model of mobility generated by the movement model generation unit 11, a human agent corresponding to the movement model representing a movable object of a person, and another agent corresponding to the movement model indicating another movable object.

As described above, the route generation unit 14 generates a movement route of the mobility agent or the human agent. The movement route of the human agent and another agent may be set based on, for example, past actual result data of a movement route in a similar building. The route generation unit 14 may generate the movement route of the human agent and another agent based on the past actual result data in the similar building.

### (Elevator Simulation Unit)

The elevator simulation unit 16 performs a simulation that simulates an operation of an elevator. The elevator simulation unit 16 outputs a result of the simulation to the input/output unit 18.

The elevator simulation unit 16 operates while communicating with the movement simulation unit 15. For example, when the movable agent in the movement simulation unit 15 makes a call, the elevator simulation unit 16 moves an elevator car to a floor where the call is made. The elevator simulation unit 16 notifies the movement simulation unit 15 that the car has arrived at the floor where the call is made and that the door of the car is opened and closed.

### (Evaluation Unit)

The evaluation unit 17 calculates a congestion evaluation index indicating a congestion status of the virtual space based on the simulation performed by the movement simulation unit 15. As the congestion evaluation index, for example, indexes for a person such as a congestion density, a flow rate, an average walking speed, and the number of times of mixture are used. However, the congestion evaluation index calculated by the evaluation unit 17 is not limited to the above. The evaluation unit 17 outputs the calculated evaluation indexes to the input/output unit 18.

The evaluation unit 17 calculates a mobility evaluation index indicating an operation status of a mobility based on the simulation performed by the movement simulation unit 15. As the mobility evaluation index, an index for the mobility, such as an operation rate of the mobility (a ratio of time other than standby to a target time), an average movement speed of a mobility, the number of times a mobility and a person are mixed, and the number of times mobilities are mixed, is used. However, the mobility evaluation index calculated by the evaluation unit 17 is not limited to the above. The evaluation unit 17 outputs the calculated mobility evaluation index to the input/output unit 18.

The evaluation unit 17 calculates an elevator evaluation index indicating an operation status of an elevator based on the simulation performed by the elevator simulation unit 16. As the elevator evaluation index, for example, an index for generally evaluating a usage status of an elevator such as an average call duration time, the number of times a call button is pressed, an average number of passengers, an average door opening time, and the number of people waiting is used. Furthermore, as the elevator evaluation index, indexes in which an influence of mobilities is considered, such as the number of people who could not board the elevator due to a mobility boarding, a waiting time occurring due to the number of people who could not board the elevator, the number of times mobilities could not board the elevator due to people boarding, and a waiting time occurring due to the number of times mobilities could not board the elevator due to people boarding, are also used. However, the elevator evaluation index calculated by the evaluation unit 17 is not limited to the above. The evaluation unit 17 outputs the calculated elevator evaluation index to the input/output unit 18.

### (Input/output unit)

The input/output unit 18 receives an input of a setting necessary for evaluation by the user. The setting necessary for the evaluation includes the above-described basic attribute related to movement of a mobility, the number of mobilities, and a period of time for evaluation. The input/output unit 18 displays information (simulation results and evaluation indexes) output from the movement simulation unit 15, the elevator simulation unit 16, and the evaluation unit 17 on a display or the like. In the mobility operation evaluation system according to the present invention, an input unit and an output unit may be separately provided.

### [Data used by mobility operation evaluation system]

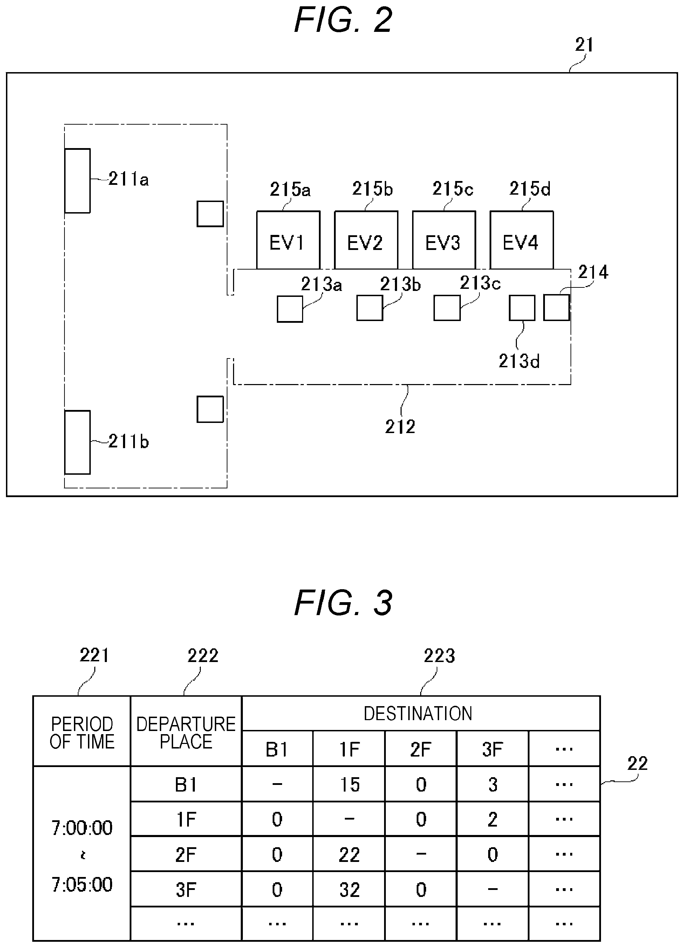

Next, data used by the mobility operation evaluation system 1 will be described with reference to Figs. 2 to 6.

The data is illustrated as an example for description, and implementation is not limited thereto. For example, data described in a table may be actually further normalized in a database, divided into a plurality of tables, and held. Here, data related to a mobility according to the present invention will be mainly described. Accordingly, the data used by the present system is not limited to the data to be described here.

### (Space Structure Data)

The space structure data 21 is data structured by associating geometric structure information of a floor layout in a building with attribute information such as passage possibility and passage conditions.

Fig. 2 is a diagram illustrating an example of the space structure data 21.

As illustrated in Fig. 2, the space structure data 21 includes doorways 211a and 211b, a passable area 212, elevator boarding standby positions 213a to 213d and 214, and elevator installation positions 215a to 215d.

The doorways 211a and 211b are information indicating doorways through which a population flow into and out of a simulation target space. The passable area 212 is information indicating an area where a person and a mobile robot can move. The passable area 212 includes, for example, a passage and an elevator hall.

The passable area 212 may be common between a person and a robot, or different passable areas may be prepared for each movement target agent. In the passable area 212, a physically passable range may be set as it is, or a range different from a physically movable range may be set to be followed for operational or control reasons.

The elevator boarding standby positions 213a to 213d are information indicating a position where people wait before boarding elevators. The elevator boarding standby position 214 is information indicating a position where a robot waits before boarding an elevator. In this way, the elevator boarding standby position can be set separately for each type of a target mobile agent according to the operation.

The elevator boarding standby positions 213a to 213d and 214 may be divided according to a method of generating an elevator call. For example, when the elevator is called for boarding by a normal call type for making a call by pressing a hall button, the elevator boarding standby positions 213a to 213d are used. On the other hand, when the robot makes a call using a robot cooperation command of the elevator, the elevator boarding standby position 214 is used.

The elevator boarding standby positions 213a to 213d and 214 may include information for performing alignment. For example, when a direction in which the elevator boarding standby positions 213a to 213d and 214 are aligned is held as information, the movement simulation unit 15 (see Fig. 1) controls the movable agents moving to the elevator boarding standby positions such that the movable agents are aligned in a defined direction.

The elevator installation positions 215a to 215d are information indicating the positions of elevator cars. Each of the elevator installation positions 215a to 215d has at least information with which an associated elevator ID can be specified.

Fig. 2 illustrates a floor layout of one floor as the space structure data 21. However, the space structure data 21 holds floor layouts of all target spaces in association with information with which floors can be identified. Each floor layout may be of any type as long as a shape and an attribute can be specified, such as a set of objects, a set of grid-like cells, and image data. The space structure data according to the present invention may be 3-dimensional space information instead of a set of 2-dimensional floors.

### (Movement Demand Data)

The movement demand data 22 is data indicating an amount of movement of a person or a robot in a building.

Fig. 3 is a diagram illustrating an example of the movement demand data 22.

The movement demand data 22 is prepared for each type of movable object. Examples of the type of mobile object include a person, a guidance mobile robot, and a transport mobile robot. The movement demand data 22 has a movement generation amount of movement that can be specified in a period of time 221, a departure place 222, and a destination 223.

The period of time 221 is a target period of time. The departure place 222 is a departure place of the target movable object. The destination 223 is a destination of the target movable object. The departure place 222 and the destination 223 are information that can specify a place on the space structure data 21. In the movement demand data 22 illustrated in Fig. 3, floors are adopted for the departure place 222 and the destination 223. However, the information with which a location can be specified may be, for example, a name of a room or a room number, or a specific area on a floor.

### (Elevator Data)

The elevator data 23 is data that defines a specification and an operation of an elevator.

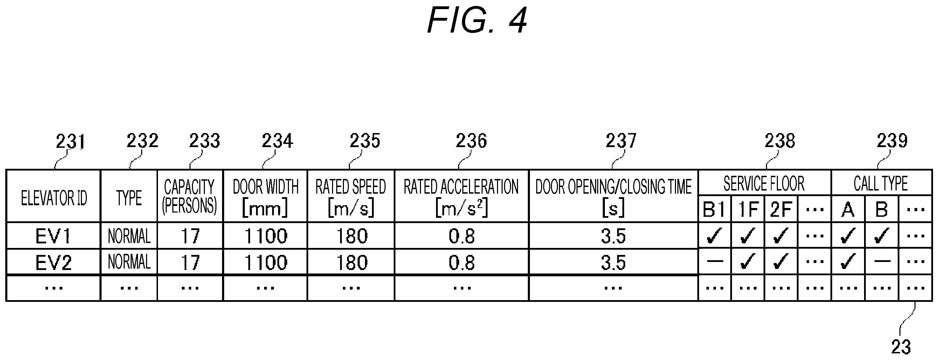

Fig. 4 is a diagram illustrating an example of the elevator data 23.

The elevator data 23 includes an elevator ID 231, a type 232, a capacity 233, a door width 234, a rated speed 235, a rated acceleration 236, a door opening/closing time 237, a service floor 238, and a call type 239.

The elevator ID 231 is a numerical value or a character string for specifying an elevator. The type 232 is data for specifying each type of elevator. Examples of the type of elevator include a normal type in which one car travels in one hoistway, a multi-car type in which a plurality of cars travels in one hoistway, and a double deck type in which the cars are two-story. The types may be classified not only by a physical structure but also by an elevator control method. For example, the type of elevator may be set in accordance with presence or absence or type of group control. The type of elevator may be set in accordance with a combination thereof.

The capacity 233 is a capacity of each elevator. In a simulation in which an operation of the elevator is simulated, it is set that boarding beyond the capacity is not possible. However, in the simulation in which the elevator is simulated, a value obtained through correction, for example, by multiplying the capacity by a fixed ratio in accordance with an actual usage status may be used as an upper limit of the capacity. The door width 234 is a door width of each elevator. The door width of the elevator affects the number of people who can get on and off at the same time. The rated speed 235 is a rated speed of each elevator. The rated acceleration 236 is a rated acceleration of each elevator.

The door open/close time 237 is a time required for opening or closing a door of each elevator. A time required for opening the door is a time in which an elevator car arrives at a target floor and then the door is completely opened. A time required for closing the door is a time in which the door starts to be closed and then the elevator car starts to be moved. When the time required for opening the door and the time required for closing the door are different, the time may be divided into a door opening time and a door closing time.

The service floor 238 is a floor where each elevator can be stopped. The elevator of which an elevator ID illustrated in Fig. 4 is specified with EV1 can be stopped on all floors B1, 1F, and 2F. On the other hand, the elevator of which an elevator ID is specified with EV2 can be stopped only in 1F and 2F among B1, 1F, and 2F.

The call type 239 is a supportable call type. In the embodiment, a call type A which is a call when a call button in an elevator hall is pressed and a call type B which is a call when an elevator is called through intersystem communication from a guidance robot are provided. When a call of the call type A is made, an elevator of which an elevator ID is either the EV 1 or the EV 2 is dispatched. On the other hand, when the call of the call type B is made, the elevator of which an elevator ID is EV1 is dispatched.

### (Mobility Information Data)

The mobility information data 24 is data including information such as a position and a state of a movable object.

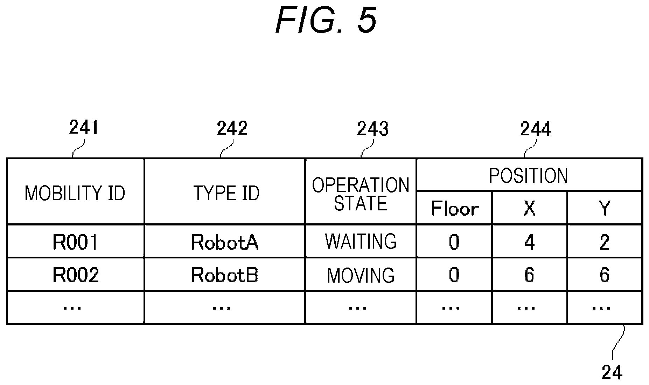

Fig. 5 is a diagram illustrating an example of the mobility information data 24.

In the embodiment, a robot (mobility) is assumed to be a mobile object, but a person may also be included in the mobile object. The mobility information data in this case also includes information such as a position and a state of a person. The mobility information data 24 includes a mobility ID 241, a type ID 242, an operation state 243, and a position 244.

The mobility ID 241 is a numerical value or a character string for specifying mobility. The type ID 242 is a numerical value or a character string for specifying the type of mobility. The type ID 242 is an ID for specifying the mobility type data 25 of a corresponding mobility.

The operation state 243 is information indicating an operation state of mobility. The operation state of a mobility is used when it is determined whether a new task can be assigned. The position 244 is information for specifying a location where mobility exists. A location where there is the mobility is represented, for example, with coordinates with which the location in the space structure data 21 is identified. "Floor" illustrated in Fig. 5 indicates a floor, and "0" indicates the lowest floor. "X" and "Y" illustrated in Fig. 5 indicate the coordinates of the 2-dimensional floor.

### (Mobility Type Data)

The mobility type data 25 is data for defining an operation of the mobility.

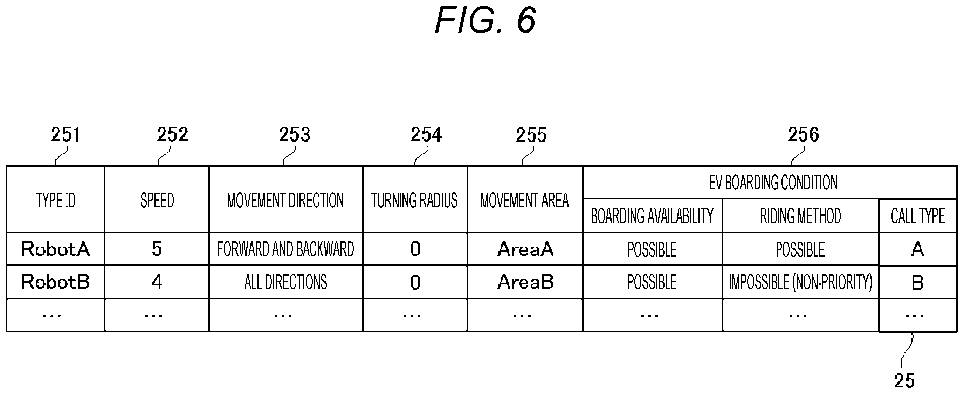

Fig. 6 is a diagram illustrating an example of the mobility type data 25.

The mobility type data 25 includes a type ID 251, a speed 252, a movement direction 253, a turning radius 254, a movement area 255, and an elevator (EV) boarding condition 256.

The type ID 251 is a numerical value or a character string for specifying the type of mobility. The speed 252 indicates a rated rate of the mobility. The speed 252 may be a plurality of speeds such as a maximum speed and an acceleration in addition to the rated speed of the normal operation. The movement direction 253 is a movable direction of the mobility. For example, for the mobility that can only rotate and move forward and backward, only the forward and backward directions are defined as a movement direction.

The turning radius 254 is a radius required for turning mobility. For example, since the mobility operating on a differential two-wheel can be turned on the spot, the turning radius is 0. On the other hand, the turning radius of the mobility turned by the steering structure is defined. The route generation unit 14 (see

Fig. 1) generates a movement route of the mobility in consideration of the turning radius 254 of the mobility. The movement area 255 is a movable area of the mobility. The movement area 255 indicates information with which the passable area 212 of the space structure data 21 can be specified.

The EV boarding condition 256 indicates information used for the mobility to cooperate with the elevator. The information used to cooperate with the elevator includes, for example, boarding possibility, a riding method, and a call type. The boarding possibility defines whether the mobility can board the elevator. The riding method defines whether the mobility can ride along with a person or another mobility. The call type defines a supportable call type.

When the riding method is "possible," the mobility can ride along with a person or another mobility. When the riding method is impossible, whether priority is given to movement of a person is included. That is, when the riding method is "impossible (priority)," boarding of the mobility is prioritized. Conversely, when the riding method is "impossible (non-priority)", boarding of a person is prioritized.

When the riding method of the mobility is "impossible (priority)," the movement simulation unit 15 performs simulation such that the mobility (the movable agent) boards the elevator even if a call from a person is made. When the riding method of the mobility is "impossible (non-priority)," the movement simulation unit 15 performs simulation so that the mobility (movable agent) does not board the elevator until there is no call from a person.

The EV boarding condition may be defined for each elevator ID (type of elevator) instead of being defined for each type ID 251 (type of mobility). The information used to cooperate with the elevator of the EV boarding condition 256 may include an elevator ID for specifying the elevator that can be boarded.

### [Mobility Operation Evaluation Process]

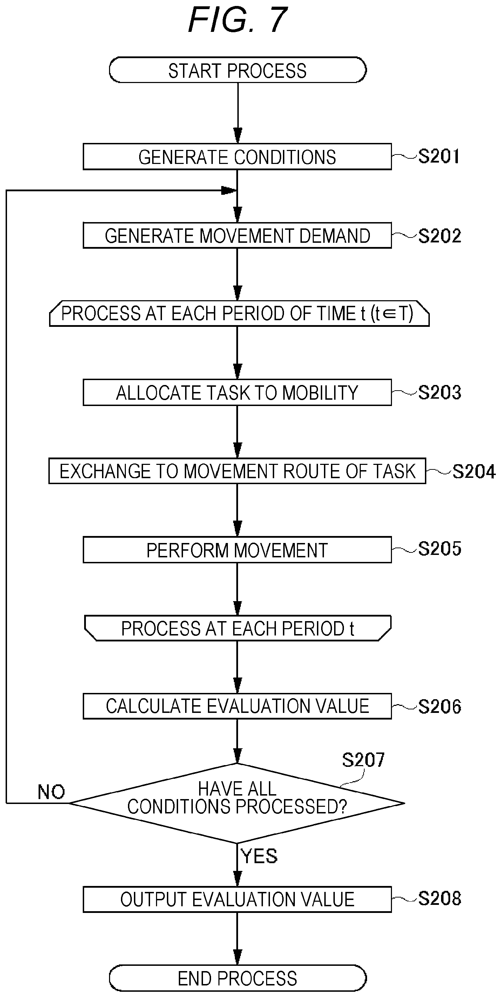

Next, the mobility operation evaluation process performed by the mobility operation evaluation system 1 will be described with reference to Fig. 7.

Fig. 7 is a flowchart illustrating a mobility operation evaluation process according to the first embodiment.

First, the user generates conditions of an operation evaluation target (S201). In step S201, for example, the number, type, initial arrangement, elevator boarding condition, movable area, and the like of mobilities are set. These settings are input to the mobility operation evaluation system 1 in accordance with conditions that the user wants to evaluate. The mobility operation evaluation system 1 may set conditions equivalent to past conditions of a similar building to generate the condition of the operation evaluation target.

In the embodiment, it is assumed that a space structure (a structure of a building, the number of elevators, or the like) and a movement demand of people are known (determined in advance) and conditions of the mobility are changed. However, in the mobility operation evaluation according to the present invention, the conditions of the space structure and the movement demand of people may be changed without changing the conditions of the mobility.

Subsequently, the movement demand generation unit 12 generates the movement demand data 22 of the mobility (S202). In the movement demand of the mobility, a plurality of patterns of mobility demand may be generated by changing conditions and random numbers.

Subsequently, the period of time T of an evaluation target is discretized, and the process from steps S203 to S205 is repeated in units of a period of time t.

First, the supervision control unit 13 associates the movement amount in the period of time t with the mobility as the movement task based on the movement demand (S203).

The movement task is information in which a series of movements obtained by adding movement of the mobility to a departure place and movement of the mobility from the destination to movement of mobility from the departure place to the destination generated from movement demand data are collected. For example, when there is a movement demand from a first floor point A to a second floor point B, movement from a location position of the mobility to the first floor point A, movement from the first floor point A to the second floor point B, and movement from the second floor point B to a mobility standby position are collected as one related movement to be set as a movement task.

A movement task with a mobility is associated based on a distance between the location position of the mobility and a position where the movement demand is generated, presence or absence of the movement task assigned to the mobility, a progress state of the movement task assigned to the mobility, and the like.

Subsequently, the route generation unit 14 generates a movement route of the mobility associated with the movement task (S204). The movement route is generated based on the mobility type data 25.

Subsequently, the movement simulation unit 15 and the elevator simulation unit 16 simulate movement of a mobility agent and movement of an elevator agent based on the generated movement route (S205).

The mobility agent is a mobile agent corresponding to a mobility model of the mobility. The elevator agent is an agent corresponding to an elevator car. The movable agent corresponding to the moving model of a person is a person agent.

In step S205, a drawing unit (not illustrated) may appropriately draw a simulation status in a virtual space and output a drawing result to the input/output unit 18. The movement simulation unit 15 and the input/output unit 18 may draw a simulation status.

In step S205, the movement simulation unit 15 and the elevator simulation unit 16 may output operation states of the mobility agent and the elevator agent to the input/output unit 18. In this case, the input/output unit 18 simply displays the operation states of the mobility agent and the elevator agent with characters, icons, and the like.

After the process from steps S203 to S205 is performed until the period of time T of the evaluation target, the evaluation unit 17 calculates each evaluation index based on a simulation result (S206).

Subsequently, the movement simulation unit 15 determines whether the simulation has been executed under all the conditions to be evaluated (S207). When the number, type, initial arrangement, elevator boarding conditions, and the like of mobilities are changed, each movement demand is generated and a plurality of simulations are performed.

When it is determined in step S207 that the simulation has not been executed under all the conditions to be evaluated (in the determination case of NO in S207), the process returns to the process of step S202, and the movement demand generation unit 12 generates the movement demand under the conditions that have not yet been evaluated.

Conversely when it is determined in step S207 that the simulation has been executed under all the conditions to be evaluated (in the determination case of YES in S207), the evaluation unit 17 outputs the evaluation condition and the evaluation index associated with each other to the input/output unit 18 (S209). After the process of step S209, the processing unit 10 ends the mobility operation evaluation process.

The evaluation unit 17 may collect a plurality of evaluation indexes related to a congestion status of people, a mobility movement status, and an operation status of the elevator under each condition into one evaluation index by a weighted average or the like and may output the evaluation index to the input/output unit 18. The evaluation unit 17 may prioritize the evaluation conditions based on the calculated one evaluation index. The drawing unit (not illustrated) may display the simulation status in which each evaluation value is calculated as a moving image or a still image on the input/output unit 18. The moving image or the still image to be displayed may be only a scene in which a specific index is bad or good.

By executing such a mobility operation evaluation process, an influence of the mobility on the population flow in the building and the operation of the elevator can be evaluated when the mobility such as a mobile robot is operated.

### [Display of Simulation Result]

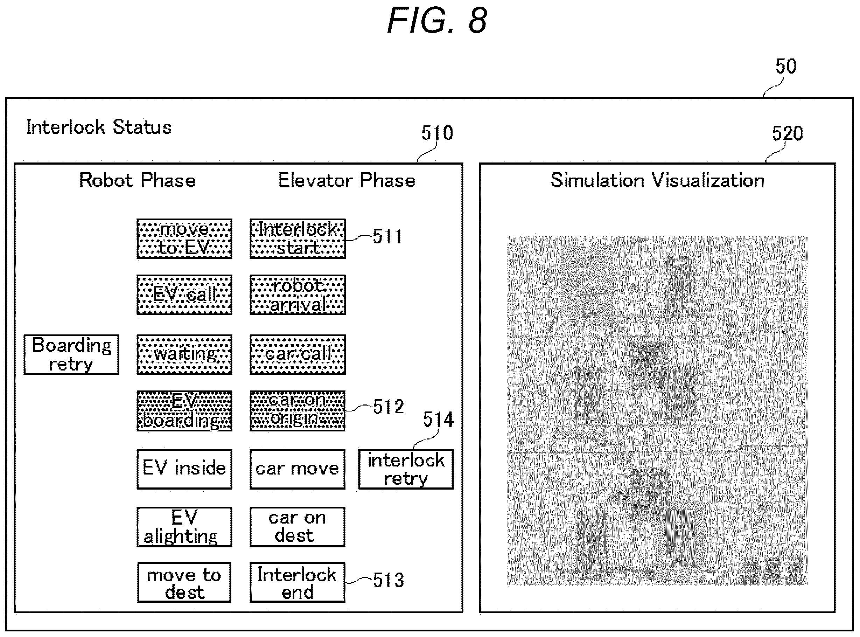

Next, display of a simulation result will be described with reference to Fig. 8.

Fig. 8 is a diagram illustrating a display example of a simulation result.

As illustrated in Fig. 8, the simulation result may be displayed by synchronizing state transition of a mobility and an elevator. The input/output unit 18 includes a display unit 50. The display unit 50 can display a state transition display screen 510 and a status display screen 520.

On the state transition display screen 510, state transitions in which a mobility (robot) state and an elevator state are arranged in sequence on the vertical direction set as a time axis are displayed. The mobility state and the elevator state adjacent to each other in the horizontal direction occur at substantially the same timing. The mobility state and the elevator state are displayed in color so that execution completion 511, execution progress 512, and non-execution 513 can be distinguished from each other.

Furthermore, an exception state 514 indicating a state of an exception process that is not a normal process is displayed on the sides of the mobility state and the elevator state. On the state transition display screen 510, a state such as progress of the exception process or error occurrence may be displayed.

On the status display screen 520, a status of the simulation in accordance with the state of the execution progress 512 is displayed.

### [Mobility Agent Movement Process]

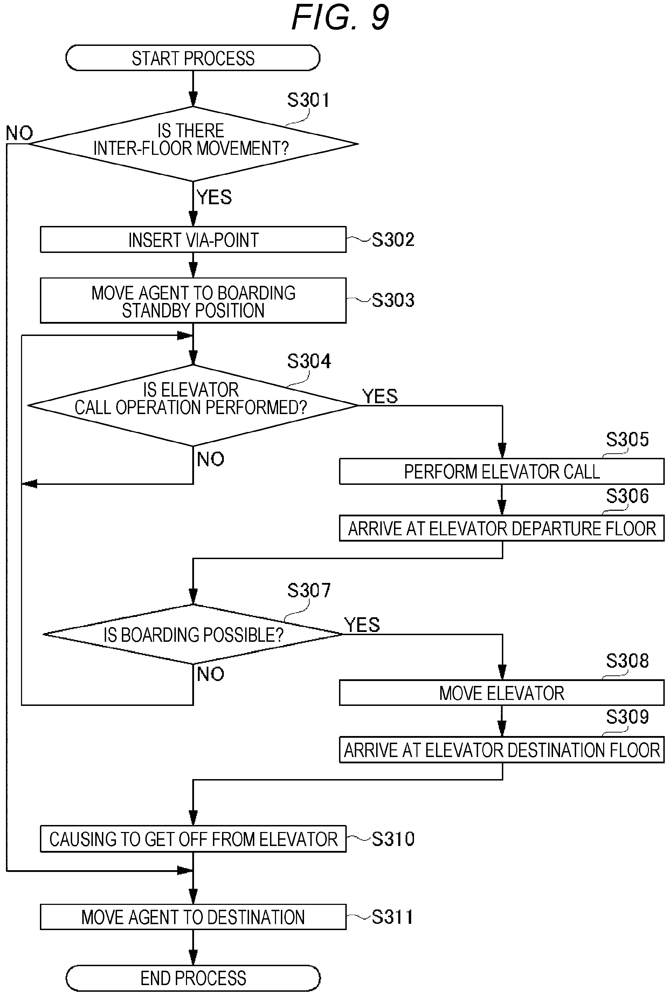

Next, a mobility agent movement process performed by the mobility operation evaluation system 1 will be described with reference to Fig. 9.

Fig. 9 is a flowchart illustrating a mobility agent movement process.

The mobility agent movement process is executed by the movement simulation unit 15 and the elevator simulation unit 16. This process is executed after a route is set for a movement model of the mobility.

First, the movement simulation unit 15 determines whether inter-floor movement is included in the generated movement route (S301). When it is determined in step S301 that the inter-floor movement is not included in the movement route (in the determination case of NO in S301), the movement simulation unit 15 performs the process of step S311.

When it is determined in step S301 that the inter-floor movement is included in the movement route (in the determination case of YES in S301), the movement simulation unit 15 inserts a via-point into the movement route (S302).

In the process of step S302, the movement route is divided into a route from the departure place to the elevator boarding standby position of the mobility and a route from the elevator to the destination. When a plurality of elevator boarding standby positions of the mobility are provided, a target elevator boarding standby position is specified in accordance with a type of mobility agent.

Subsequently, the movement simulation unit 15 moves the mobility agent to an elevator boarding standby position which is the via-point (S303).

Subsequently, the movement simulation unit 15 determines whether an elevator call operation has been performed (S304). In step S304, when an elevator ride method of the mobility agent is "possible" and another mobile agent does not make a call, the movement simulation unit 15 performs a call operation with a call type specified in accordance with the type of mobility agent. Conversely, when the elevator riding method of the mobility agent is "possible" and a human agent makes a call, the movement simulation unit 15 does not perform a new call operation.

When the elevator riding method of the mobility agent is "impossible (priority)," the movement simulation unit 15 performs a call operation with a call type specified in accordance with the type of mobility agent.

When the elevator riding method of the mobility agent is "impossible (non-priority)" and the human agent makes a call, the human agent waits until the call ends. When the elevator riding method of the mobility agent is "impossible (non-priority)" and the human agent does not make a call, the movement simulation unit 15 makes a call with a call type specified in accordance with the type of mobility agent.

In step S304, when the mobility agent waits until the end of the call of the human agent, it is determined that the elevator call operation is not performed. When it is determined in step S304 that the call operation of the elevator is not performed (in the determination case of NO in S304), the movement simulation unit 15 repeats step S304.

Conversely, in step S304, when the call operation is performed or when the elevator riding method of the mobility agent is "possible" and the human agent makes a call, it is determined that the elevator call operation is performed. When it is determined in step S304 that the elevator call operation is performed (in the determination case of YES in S304), the elevator simulation unit 16 executes the elevator call with the call type performed in step S304 (S305).

Subsequently, the elevator simulation unit 16 notifies the movement simulation unit 15 that the elevator agent arrives at a departure floor and the door of a car is opened (S306).

Subsequently, the movement simulation unit 15 determines whether the mobility agent can board the elevator agent that has arrived at the departure floor (S307). The determination in step S307 may be made by the elevator simulation unit 16 or may be made by both the movement simulation unit 15 and the elevator simulation unit 16.

In step S307, when the elevator riding method of the mobility agent is "possible" and the number of passengers of the car is less than the capacity, the movement simulation unit 15 determines that boarding is possible. Conversely, when the elevator boarding method of the mobility agent is "possible" and the number of passengers of the car exceeds the capacity, the movement simulation unit 15 determines that boarding is not possible. As the capacity, the capacity 233 (see Fig. 4) in the elevator data 23 may be used, or a capacity obtained through correction, for example, by multiplying the capacity 233 by a certain ratio may be used.

In step S307, when the elevator riding method of the mobility agent is "impossible (priority)," the movement simulation unit 15 determines that the mobility agent can board the elevator and determines that the human agent cannot board the elevator.

In step S307, when the elevator riding method of the mobility agent is "impossible (non-priority)," the movement simulation unit 15 determines that the mobility agent cannot board the elevator and determines that the human agent can board the elevator.

When it is determined in step S307 that the mobility agent cannot board the elevator agent that has arrived at the departure floor (in the determination case of NO in S307), the movement simulation unit 15 moves the process to step S304.

When it is determined in step S307 that the mobility agent can board the elevator agent that has arrived at the departure floor (YES in S307), the movement simulation unit 15 allows the mobility agent to board the elevator agent. Then, the elevator simulation unit 16 moves the elevator agent to floor where there is a destination (destination floor) (S308).

Subsequently, the elevator simulation unit 16 notifies the movement simulation unit 15 that the elevator agent has arrived at the destination floor and the door of the car has been opened (S309). Subsequently, the movement simulation unit 15 causes the mobility agent to get off the elevator agent (S310).

After the process of step S310 or when NO is determined in step S301, the movement simulation unit 15 moves the mobility agent to the destination (S311). After the process of step S311, the movement simulation unit 15 and the elevator simulation unit 16 end the mobility agent movement process.

### <Second Embodiment>

### [Configuration of Mobility Operation Evaluation System]

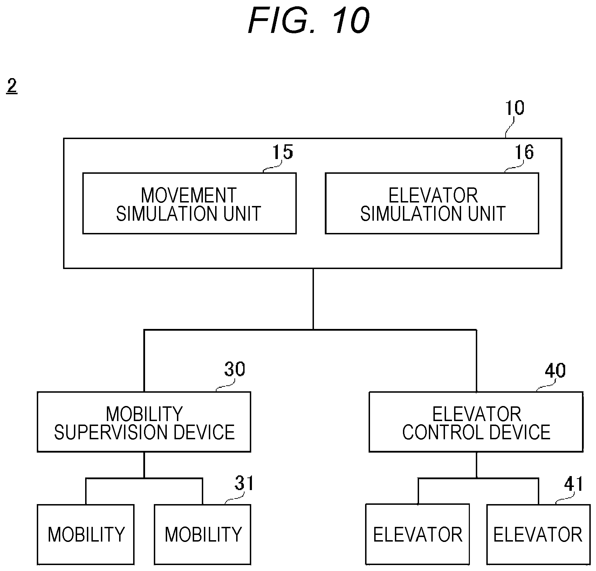

Next, a configuration of a mobility operation evaluation system according to a second embodiment will be described with reference to Fig. 10.

Fig. 10 is a block diagram illustrating a functional configuration of a mobility operation evaluation system according to the second embodiment.

The mobility operation evaluation system 2 according to the second embodiment evaluates a mobility operation using both a mobility and an elevator which are in a virtual space and the real space. A basic configuration of the mobility operation evaluation system 2 according to the second embodiment is similar to that of the mobility operation evaluation system 1 according to the first embodiment (see Fig. 1). Hereinafter, description of a configuration common to the mobility operation evaluation system 1 will be omitted, and only different configurations will be described with reference to Fig. 10.

The mobility operation evaluation system 2 includes a processing unit 10 that performs calculation or the like, and a recording unit 20 (not illustrated) that records data.

The processing unit 10 includes a movement simulation unit 15 and an elevator simulation unit 16. The processing unit 10 includes a movement model generation unit 11, a movement demand generation unit 12, a supervision control unit 13, a route generation unit 14, an evaluation unit 17, and an input/output unit 18 (none of which are illustrated). These units are distinguished for facilitating description, and may actually be configured as the same software or may be divided in accordance with different methods.

The movement simulation unit 15 is connected to the mobility supervision device 30. The mobility supervision device 30 manages a plurality of actual mobility machines 31 such as mobile robots. The movement simulation unit 15 acquires positions and states of the actual mobility machines 31 from the mobility supervision device 30, and outputs the acquired positions and states as the positions and states of mobility agents in simulation.

That is, the movement simulation unit 15 moves a first mobility agent generated from the movement model and a second mobility agent of an actual machine connection type in the simulation. The first mobility agent corresponds to the first mobile agent according to the present invention. The second mobility agent corresponds to the second mobile agent according to the present invention.

The mobility supervision device 30 and the actual mobility machine 31 are not necessarily the actual machines and may be, for example, emulation devices simulating actual machines or devices reproducing operations of the actual machines based on logs of the actual machines. The second mobility agent can be driven in response to a control command including a movement command. The movement simulation unit 15 may acquire a position and a state from each actual mobility machine 31 without being involved in the mobility supervision device 30.

The elevator simulation unit 16 is connected to the elevator control device 40. The elevator control device 40 controls a plurality of actual elevator machines 41. The elevator simulation unit 16 acquires the positions and states of the plurality of actual elevator machines 41 from the elevator control device 40, and outputs the acquired positions and states as the positions and states of the elevator agents in the simulation.

That is, the elevator simulation unit 16 moves the first elevator agent generated from the elevator model and the second elevator agent of the actual machine connection type in the simulation.

The elevator control device 40 and the actual elevator machine 41 are not necessarily actual machines and may be, for example, emulation devices simulating actual machines or devices reproducing operations of the actual machines based on logs of the actual machines. The elevator simulation unit 16 may acquire the position and state from each actual elevator machine 41 without being involved in the elevator control device 40.

The elevator agent of the actual machine connection type can be controlled using an application programming interface (API) provided by the elevator control device 40 or the actual elevator machine 41. For example, the API making an elevator call by a robot is associated with a call type included in the elevator data of the mobility operation evaluation system 2. When the associated call type is called in the simulation, a call of the actual elevator machine 41 is actually made via the elevator agent of the actual machine connection type.

The mobility operation evaluation system 2 does not necessarily need to perform connection with the actual mobility machine 31 and the actual elevator machine 41. The mobility operation evaluation system 2 may have a configuration in which only one of the actual mobility machine 31 and the actual elevator machine 41 is connected and the other is not connected.

### [Mobility Operation Evaluation Process]

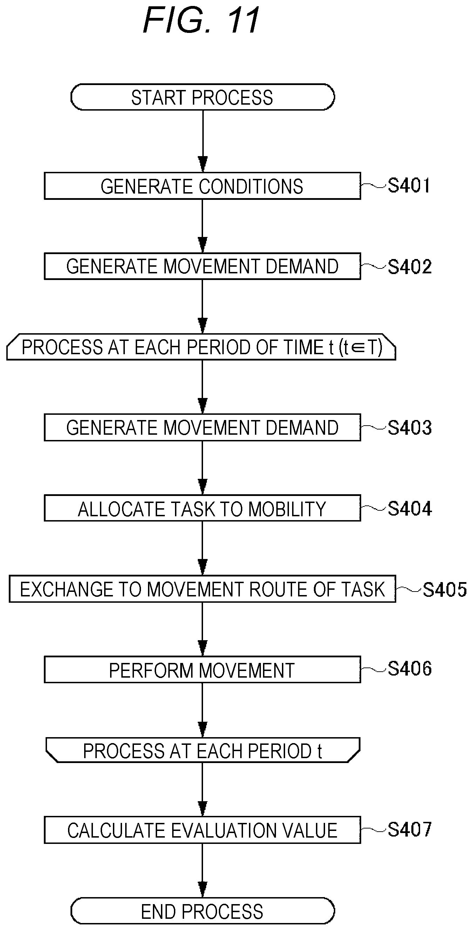

Next, a mobility operation evaluation process performed by the mobility operation evaluation system 2 will be described with reference to Fig. 11.

Fig. 11 is a flowchart illustrating a mobility operation evaluation process according to the second embodiment.

First, the user generates conditions of an operation evaluation target (S401). In step S401, for example, the number, type, initial arrangement, elevator boarding condition, movable area, and the like of mobilities are set. These settings are input to the mobility operation evaluation system 1 in accordance with conditions that the user wants to evaluate. The mobility operation evaluation system 1 may set conditions equivalent to past conditions of a similar building to generate the condition of the operation evaluation target.

In step S401, a connection setting between the actual mobility machine 31 and the mobility operation evaluation system 2 (the movement simulation unit 15) is performed. In the connection setting, for example, an information exchange protocol, a connection destination, authentication information, and the like are set.

When connection between the mobility supervision device 30 and the mobility operation evaluation system 2 is performed, it is selected whether allocation of the movement demand to the mobility is performed by the supervision control unit 13 or the mobility supervision device 30. When the mobility supervision device 30 allocates the movement demand to the mobilities, the mobility operation evaluation system 2 transmits information such as the mobility information data 24 and the mobility type data 25 to the mobility supervision device 30. Accordingly, the mobility supervision device 30 can regard the mobility agent as an actual mobility machine and allocate the movement demand.

Subsequently, the movement demand generation unit 12 generates the movement demand data 22 of the mobility (S402). The movement demand data 22 is not necessarily generated in step S402, and may be generated in step S403 to be described below.

Subsequently, the period of time T of an evaluation target is discretized, and the process from step S403 to step S406 is repeated in units of the period of time t. When the actual mobility machine 31 or the actual elevator machine 41 is connected to the mobility operation evaluation system 2, progress in the time period t is performed in synchronization with a real time. However, when an operation is reproduced based on a movement record (log) of the actual mobility machine 31 or the actual elevator machine 41, when an emulator is used, or the like, the simulation may be executed at any speed as in the first embodiment.

First, the movement demand is manually generated (S403). For example, the user designates a mobility and a movement destination (not limited to one, and a series of movements including a via-point is included) using the input/output unit 18 and generates the movement demand. In step S403, the movement demand data 22 generated in step S402 is changed or added. By generating the basic movement demand data 22 in step S402, the process of step S403 can be simplified.

The movement demand may be manually generated for either the mobility agent generated from the movement model or the mobility agent of the actual machine connection type.

Subsequently, the supervision control unit 13 or the mobility supervision device 30 associates the movement amount in the period of time t with the mobility as a movement task based on the movement demand (S404). The mobility associated here may be either a mobility agent generated from the movement model or the mobility agent of the actual machine connection type. The mobility assigned by the user may be designated.

Subsequently, a movement route of the mobility associated with the movement task is generated (S405). When the mobility associated with the movement task is the mobility agent generated from the movement model, the route generation unit 14 generates the movement route based on the mobility type data 25.

Conversely, when the mobility associated with the movement task is a mobility agent of an actual machine connection type, only the movement destination is transmitted to the mobility supervision device 30 or the actual mobility machine 31. Accordingly, the mobility supervision device 30 or the actual mobility machine 31 calculates the movement route.

Subsequently, the movement simulation unit 15 and the elevator simulation unit 16 simulate the movement of the mobility agent and the movement of the elevator agent based on the generated movement route (S406).

In step S406, the movement of the mobility agent of the actual machine connection type is not calculated by the simulation, but position information is acquired from the mobility supervision device 30 or the actual mobility machine 31, and the position 244 of the corresponding mobility information data 24 is updated. The movement of the elevator agent of the actual machine connection type is also acquired from the elevator control device 40 or the actual elevator machine 41 without calculating the position and state by the simulation.

After the process from step S403 to step S406 is performed until the period of time T of the evaluation target, the evaluation unit 17 calculates each evaluation index based on the simulation result. Then, the evaluation unit 17 outputs the evaluation condition and the evaluation index to the input/output unit 18 in association (S407). After the process of step S407, the processing unit 10 ends the mobility operation evaluation process.

As described above, in the second embodiment, the mobility supervision device 30 and the elevator control device 40 or emulation devices corresponding thereto are connected to the mobility operation evaluation system 2. Accordingly, the control results of the mobility supervision device 30 and the elevator control device 40 can be displayed and visualized in the virtual space using the mobility operation evaluation system 2. Since the evaluation index is calculated and displayed, the evaluation index can be confirmed through display of the virtual space.

For example, when the mobility supervision device 30 and the actual mobility machine 31 are developed, the mobility agent generated from the mobility model can be utilized in the mobility operation evaluation system 2 even in a case where there is only one actual mobility machine 31. As a result, the operation evaluation of the actual mobility machine 31 can be performed by simulating the behavior in a case where there is a plurality of the actual mobility machines 31.

The mobility operation evaluation system 2 can evaluate an algorithm for controlling the mobility of the mobility supervision device 30 by utilizing the mobility agent generated from the movement model. Accordingly, it is possible to develop the mobility supervision device 30 without connecting any one actual mobility machine to the mobility operation evaluation system 2.

When cooperation between the mobility and the elevator is developed, the actual mobility machine or the actual elevator machine may be connected to the mobility operation evaluation system 2, and the unconnected machine may be simulated by the simulation included in the mobility operation evaluation system 2. Accordingly, a behavior of a cooperation operation between the mobility and the elevator can be confirmed and evaluated using the actual mobility machine or the actual elevator machine.

### <Conclusion>

The mobility operation evaluation system 1 according to the above-described first embodiment evaluates movement of a plurality of movable objects (mobilities, people, and the like) in a building, including elevators. The mobility operation evaluation system 1 includes the movement model generation unit 11, the movement demand generation unit 12, the supervision control unit 13, the route generation unit 14, the movement simulation unit 15, the elevator simulation unit 16, the evaluation unit 17, and the input/output unit 18 (an output unit).

The movement model generation unit 11 generates a movement model defining a condition related to movement of a plurality of movable objects. The movement demand generation unit 12 calculates a movement demand for each movement model. The supervision control unit 13 allocates a movement demand to each movement model. The route generation unit 14 generates the movement route of each movement model based on the movement demand of each movement model. The movement simulation unit 15 simulates movement of each movement model based on the movement route of each movement model. The elevator simulation unit 16 simulates an operation of the elevator. The evaluation unit 17 calculates evaluation values related to the movement of the plurality of movement models in the building and the operation of the elevator from the simulation results of the movement simulation unit and the elevator simulation unit. The input/output unit 18 outputs the evaluation values calculated by the evaluation unit.

Accordingly, when mobility such as a mobile robot is operated, it is possible to evaluate an influence of a mobility on a population flow in a building and an operation of an elevator. As a result, it is possible to evaluate a congestion status of the elevator in an environment in which there is the mobility.

The movement model generation unit 11 of the mobility operation evaluation system 1 according to the first embodiment generates a movement model of a mobility that holds at least a movable direction and a turning radius as parameters.

Accordingly, the route generation unit 14 can accurately generate a movement route of each movement model. As a result, the accuracy of the evaluation of a congestion status of the elevator when the mobility is operated can be improved.

The movement model generation unit 11 of the mobility operation evaluation system 1 according to the above-described first embodiment generates a movement model of mobility that holds, as a parameter, whether to be able to ride on the elevator along with another movable object.

Accordingly, the movement simulation unit 15 can accurately simulate movement of a movement model such as a mobility and a person. As a result, the accuracy of the evaluation of a congestion status of the elevator when the mobility is operated can be improved.

The movement simulation unit 15 of the mobility operation evaluation system 2 according to the above-described second embodiment includes at least one of the first mobility agent (first movable agent) generated based on the movement model and the second mobility agent (second movable agent) generated based on the information on the mobility of the actual machine.

Accordingly, when the second mobility agent is used, the mobility movement can be simulated based on mobility information of an actual machine. As a result, when there is only one mobility of the actual machine, an operation of the mobility can be evaluated by simulating a behavior in a case where there are a plurality of mobilities of the actual machine. Then, the evaluation result can be used for development of the mobility.

The elevator simulation unit 16 of the mobility operation evaluation system 2 according to the above-described second embodiment includes at least one of the first elevator agent generated based on an elevator model and the second elevator agent generated based on information regarding the actual elevator.

Accordingly, when the second elevator agent is used, an operation of the elevator can be simulated based on the information regarding the elevator of the actual machine. As a result, it is possible to evaluate an influence regarding a mobility on the population flow and the operation of the elevator in the building based on the operation of the actual elevator.

The evaluation unit 17 of the mobility operation evaluation system 1 according to the above-described first embodiment calculates an evaluation value of an evaluation index for evaluating a congestion status in a target space, an operation status of the mobility, and an operation status of the elevator.

Accordingly, when the mobility is operated, it is possible to confirm a relationship between the operation status of the mobility and the congestion status in the target space, and to confirm the relationship between the operation status of the elevator and the congestion status in the target space. As a result, it is possible to review the operation of the mobility and the operation of the elevator in accordance with the congestion status in the target space.

As the evaluation index of the congestion status in the target space of the mobility operation evaluation system 1 according to the above-described first embodiment, at least one index among congestion density, a flow rate, an average walking speed, and a number of crossings is used.

Accordingly, it is possible to accurately evaluate the congestion status in the target space.

As the evaluation index of the mobility operation status of the mobility operation evaluation system 1 according to the first embodiment described above, at least one index of an operation rate of the mobility, an average movement speed, and the number of times of mixing of mobility and a person is used.

Accordingly, it is possible to accurately evaluate the operation status of mobility.

As the evaluation index of the operation status of the elevator of the mobility operation evaluation system 1 according to the first embodiment described above, at least one index of an average call duration time, the number of times a call button is pressed, an average number of passengers, an average door opening time, and the number of people waiting is used.

Accordingly, it is possible to accurately evaluate an operation status of the elevator.

The input/output unit 18 (the output unit) of the mobility operation evaluation system 1 according to the above-described first embodiment displays a state transition of a change in the display in accordance with the operation status by arranging the operation states of the processes in which the mobility and the elevator are moved in conjunction with each other on the time axis.

Accordingly, it is possible to visually confirm a status in which the mobility and the elevator are moved in conjunction with each other. It is possible to ascertain movement of the mobility and operation of the elevator to be performed subsequently. Furthermore, it is possible to visually recognize the flow of the operation of the entire simulation process.

The mobility operation evaluation system 1 according to the above-described first embodiment includes the input/output unit 18 (input unit) that receives an input of a setting necessary for evaluation. Then, the movement model generation unit 11 generates the movement model in accordance with the setting necessary for the evaluation.

Accordingly, the user can appropriately set the condition related to the movement of the movement model.

The mobility operation evaluation system 1 (simulation system) according to the above-described first embodiment simulates movement of a plurality of movable objects (mobilities, people, and the like) in a building including an elevator. The mobility operation evaluation system 1 includes the movement model generation unit 11, the movement demand generation unit 12, the supervision control unit 13, the route generation unit 14, the movement simulation unit 15, the elevator simulation unit 16, and the input/output unit 18 (output unit).

The movement model generation unit 11 generates a movement model defining a condition related to movement of a plurality of movable objects. The movement demand generation unit 12 calculates a movement demand for each movement model. The supervision control unit 13 allocates a movement demand to each movement model. The route generation unit 14 generates the movement route of each movement model based on the movement demand of each movement model. The movement simulation unit 15 simulates movement of each movement model based on the movement route of each movement model. The elevator simulation unit 16 simulates an operation of the elevator. The input/output unit 18 outputs simulation results of the movement simulation unit 15 and the elevator simulation unit 16.

As a result, it is possible to visually recognize the operation of the elevator and the movement of the movement model including the mobility when the mobility such as a mobile robot is operated. It is possible to visually confirm a period or an area in which movable objects are concentrated, a period in which an elevator operation is frequent, a congestion state of the elevator, and the like.

The mobility operation evaluation method by the mobility operation evaluation system 1 according to the first embodiment described above evaluates movement of a plurality of movable objects (mobility, people, and the like) in a building including an elevator. The mobility operation evaluation method includes a model creation process, a movement demand generation process, an allocation process, a route generation process, a movement simulation process, an elevator simulation process, an evaluation calculation process, and an output process.

In the model creation process, a movement model defining a condition related to movement of a plurality of movable objects is generated. In the movement demand generation process, a movement demand of each movement model is calculated. In the allocation process, a movement demand is allocated to each movement model. In the route generation process, the movement route of each movement model is generated based on the movement demand of each movement model. In the movement simulation process, movement of each movement model is simulated based on the movement route of each movement model. In the elevator simulation process, an operation of the elevator is simulated. In the evaluation calculation process, evaluation values related to movement of the plurality of movement models in the building and the operation of the elevator are calculated from simulation results of the movement simulation process and the elevator simulation process. In the output process, the evaluation value calculated in the evaluation calculation process is output.

Accordingly, when mobility such as a mobile robot is operated, it is possible to evaluate an influence of a mobility on a population flow in a building and an operation of an elevator. As a result, the congestion status of the elevator can be evaluated even in an environment in which there is a mobility.

The present invention is defined by the appended claims.

For example, the above-described embodiments have been described in detail in order to facilitate understanding of the present invention, and the present invention is not limited to embodiments including all the configurations described herein.

### Reference Signs List

- 1, 2: Mobility operation evaluation system (simulation system)
- 10: Processing unit
- 11: Movement model generation unit
- 12: Movement demand generation unit
- 13: Supervision control unit
- 14: Route generation unit
- 15: Movement simulation unit
- 16: Elevator simulation unit
- 17: Evaluation unit
- 18: Input/output unit
- 20: Recording unit
- 21: Space structure data
- 22: Movement demand data
- 23: Elevator data
- 24: Mobility information data
- 25: Mobility type data
- 30: Mobility supervision device
- 31: Actual mobility machine
- 40: Elevator control device
- 41: Actual elevator machine
- 50: Display unit
- 510: State transition display screen
- 520: Status display screen

## Claims

1. A mobility operation evaluation system (1, 2) that evaluates movement of a plurality of movable objects including a person and an autonomous mobile robot in a building including an elevator, the mobility operation evaluation system (1, 2), comprising:
a movement model generation unit (11) configured to generate a movement model defining a condition related to the movement of the plurality of movable objects;
a movement demand generation unit (12) configured to calculate a movement demand of each movement model;
a supervision control unit (13) configured to allocate the movement demand to each movement model;
a route generation unit (14) configured to generate a movement route of each movement model based on the movement demand of each movement model;
a movement simulation unit (15) configured to simulate movement of each movement model based on the movement route of each movement model;
an elevator simulation unit (16) configured to simulate an operation of the elevator;
an evaluation unit (17) configured to calculate evaluation values related to movement of the plurality of movement models in the building and the operation of the elevator from simulation results of the movement simulation unit (15) and the elevator simulation unit (16); and
an output unit configured to output the evaluation values calculated by the evaluation unit (17),
**characterized in that** the movement model generation unit (11) generates a movement model of the autonomous mobile robot that holds, as a parameter, whether riding along with another movable object that boards the elevator is possible.

2. The mobility operation evaluation system (1, 2) according to claim 1, **characterized in that** the movement model generation unit (11) generates a movement model of the autonomous mobile robot that holds at least a movable direction and a turning radius as parameters.

3. The mobility operation evaluation system (1, 2) according to claim 1, **characterized in that** the movement simulation unit (15) includes at least one of a first movable agent generated based on a movement model and a second agent generated based on information on the mobility of an actual machine.

4. The mobility operation evaluation system (1, 2) according to claim 1, **characterized in that** the elevator simulation unit (16) includes at least one of a first elevator agent generated based on an elevator model and a second elevator agent generated based on information of an actual elevator.

5. The mobility operation evaluation system (1, 2) according to claim 1, **characterized in that** the evaluation unit (17) calculates an evaluation value of an evaluation index for evaluating a congestion status in a target space, an operation status of the autonomous mobile robot and an operation status of the elevator.

6. The mobility operation evaluation system (1, 2) according to claim 5, **characterized in that** at least one index of a congestion density, a flow rate, an average walking speed, and a number of crossings is used as an evaluation index of a congestion state in the target space.

7. The mobility operation evaluation system (1, 2) according to claim 5, **characterized in that** at least one index of an operation rate of a autonomous mobile robot, an average movement speed, and the number of times an autonomous mobile robot and a person are mixed is used as an evaluation index of the operation status of the autonomous mobile robot.

8. The mobility operation evaluation system (1, 2) according to claim 5, **characterized in that** at least one index of an average call duration time, the number of times a call button is pressed, an average number of passengers, an average door opening time, and the number of people waiting is used as an evaluation index of the operation status of the elevator.

9. The mobility operation evaluation system (1, 2) according to claim 1, **characterized in that** the output unit arranges each operation status on a time axis and displays a state transition of a change in the display in accordance with the operation status for a process in which the autonomous mobile robot and the elevator move in conjunction with each other.

10. The mobility operation evaluation system (1, 2) according to claim 1, further comprising:
an input unit configured to receive an input of a setting necessary for evaluation, **characterized in that**
the movement model generation unit (11) generates a movement model in accordance with a setting necessary for the evaluation.

11. A simulation system that simulates movement of a plurality of movable objects including a person and an autonomous mobile robot in a building including an elevator, the simulation system comprising:
a movement model generation unit (11) configured to generate a movement model defining a condition related to the movement of the plurality of movable objects;
a movement demand generation unit (12) configured to calculate a movement demand of each movement model;
a supervision control unit (13) configured to allocate the movement demand to each movement model;
a route generation unit (14) configured to generate a movement route of each movement model based on the movement demand of each movement model;
a movement simulation unit (15) configured to simulate movement of each movement model based on the movement route of each movement model;
an elevator simulation unit (16) configured to simulate an operation of the elevator; and
an output unit configured to output simulation results of the movement simulation unit (15) and the elevator simulation unit (16),
**characterized in that** the movement model generation unit (11) generates a movement model of the autonomous mobile robot that holds, as a parameter, whether riding along with another movable object that boards the elevator is possible.

12. A mobility operation evaluation method of evaluating movement of a plurality of movable objects including a person and an autonomous mobile robot in a building including an elevator, the method comprising:
a movement model generation process of generating a movement model defining a condition related to the movement of the plurality of movable objects;
a movement demand generation process of calculating a movement demand of each movement model;
an allocation process of allocating the movement demand to each movement model;
a route generation process of generating a movement route of each movement model based on the movement demand of each movement model;
a movement simulation process of simulating movement of each movement model based on the movement route of each movement model;
an elevator simulation process of simulating an operation of the elevator;
an evaluation calculation process of calculating evaluation values related to movement of the plurality of movement models in the building and the operation of the elevator from simulation results of the movement simulation process and the elevator simulation process; and
an output process of outputting the evaluation values calculated in the evaluation calculation process,
**characterized in that**, in the movement model generation process, a movement model of the autonomous mobile robot is generated that holds, as a parameter, whether riding along with another movable object that boards the elevator is possible.

## Patentansprüche

1. Mobilitätsbetriebsbewertungssystem (1, 2), das eine Bewegung einer Vielzahl von bewegbaren Objekten, einschließlich einer Person und eines autonomen mobilen Roboters in einem Gebäude, das einen Aufzug umfasst, bewertet, wobei das Mobilitätsbetriebsbewertungssystem (1, 2) Folgendes umfasst:
eine Bewegungsmodellerzeugungseinheit (11), die dazu ausgelegt ist, ein Bewegungsmodell zu erzeugen, welches eine mit der Bewegung der Vielzahl von bewegbaren Objekten zusammenhängende Bedingung definiert;
eine Bewegungsnachfrageerzeugungseinheit (12), die dazu ausgelegt ist, eine Bewegungsnachfrage jedes Bewegungsmodells zu berechnen;
eine Überwachungssteuereinheit (13), die dazu ausgelegt ist, die Bewegungsnachfrage jedem Bewegungsmodell zuzuweisen;
eine Routenerzeugungseinheit (14), die dazu ausgelegt ist, eine Bewegungsroute jedes Bewegungsmodells basierend auf der Bewegungsnachfrage jedes Bewegungsmodells zu erzeugen;
eine Bewegungssimulationseinheit (15), die dazu ausgelegt ist, eine Bewegung jedes Bewegungsmodells basierend auf der Bewegungsroute jedes Bewegungsmodells zu simulieren;
eine Aufzugssimulationseinheit (16), die dazu ausgelegt ist, einen Betrieb des Aufzugs zu simulieren;
eine Bewertungseinheit (17), die dazu ausgelegt ist, mit einer Bewegung der Vielzahl von Bewegungsmodellen in dem Gebäude und dem Betrieb des Aufzugs zusammenhängende Bewertungswerte anhand von Simulationsergebnissen der Bewegungssimulationseinheit (15) und der Aufzugssimulationseinheit (16) zu berechnen; und
eine Ausgabeeinheit, die dazu ausgelegt ist, die durch die Bewertungseinheit (17) berechneten Bewertungswerte auszugeben,
**dadurch gekennzeichnet, dass** die Bewegungsmodellerzeugungseinheit (11) ein Bewegungsmodell des autonomen mobilen Roboters erzeugt, welches als einen Parameter enthält, ob ein Mitfahren mit einem anderen bewegbaren Objekt, das den Aufzug betritt, möglich ist.

2. Mobilitätsbetriebsbewertungssystem (1, 2) nach Anspruch 1, **dadurch gekennzeichnet, dass** die Bewegungsmodellerzeugungseinheit (11) ein Bewegungsmodell des autonomen mobilen Roboters erzeugt, welches zumindest eine Bewegungsrichtung und einen Drehradius als Parameter enthält.

3. Mobilitätsbetriebsbewertungssystem (1, 2) nach Anspruch 1, **dadurch gekennzeichnet, dass** die Bewegungssimulationseinheit (15) zumindest einen eines ersten bewegbaren Agenten, der basierend auf einem Bewegungsmodell erzeugt wird, und einen zweiten Agenten, der basierend auf Informationen über die Mobilität einer tatsächlichen Maschine erzeugt wird, umfasst.

4. Mobilitätsbetriebsbewertungssystem (1, 2) nach Anspruch 1, **dadurch gekennzeichnet, dass** die Aufzugssimulationseinheit (16) zumindest einen aus einem ersten Aufzugsagenten, der basierend auf einem Aufzugsmodell erzeugt wurde, und einem zweiten Aufzugsagenten, der basierend auf Informationen über einen tatsächlichen Aufzug erzeugt wurde, umfasst.

5. Mobilitätsbetriebsbewertungssystem (1, 2) nach Anspruch 1, **dadurch gekennzeichnet, dass** die Bewertungseinheit (17) einen Bewertungswert eines Bewertungsindex zum Bewerten eines Überlastungsstatus in einem Zielraum, eines Betriebsstatus des autonomen mobilen Roboters und eines Betriebsstatus des Aufzugs berechnet.

6. Mobilitätsbetriebsbewertungssystem (1, 2) nach Anspruch 5, **dadurch gekennzeichnet, dass** zumindest ein Index einer Überlastungsdichte, einer Strömungsrate, einer mittleren Gehgeschwindigkeit und einer Anzahl von Kreuzungen als einen Bewertungsindex eines Überlastungszustands in dem Zielraum verwendet wird.

7. Mobilitätsbetriebsbewertungssystem (1, 2) nach Anspruch 5, **dadurch gekennzeichnet, dass** zumindest ein Index einer Betriebsrate eines autonomen mobilen Roboters, einer mittleren Bewegungsgeschwindigkeit und der Anzahl von Malen, die ein autonomer mobiler Roboter und eine Person sich vermischen, als Bewertungsindex des Betriebsstatus des autonomen mobilen Roboters verwendet wird.

8. Mobilitätsbetriebsbewertungssystem (1, 2) nach Anspruch 5, **dadurch gekennzeichnet, dass** zumindest ein Index einer mittleren Rufdauerzeit, die Anzahl von Malen, die ein Rufknopf gedrückt wird, eine mittlere Anzahl von Fahrgästen, eine mittlere Türöffnungszeit und die Anzahl wartender Personen als Bewertungsindex des Betriebsstatus des Aufzugs verwendet wird.

9. Mobilitätsbetriebsbewertungssystem (1, 2) nach Anspruch 1, **dadurch gekennzeichnet, dass** die Ausgabeeinheit jeden Betriebsstatus auf einer Zeitachse anordnet und einen Zustandsübergang einer Änderung der Anzeige entsprechend dem Betriebsstatus für einen Prozess, in dem sich der autonome mobile Roboter und der Aufzug in Verbindung miteinander bewegen, anzeigt.

10. Mobilitätsbetriebsbewertungssystem (1, 2) nach Anspruch 1, ferner umfassend:
eine Eingabeeinheit, die dazu ausgelegt ist, eine Eingabe einer für die Bewertung erforderlichen Einstellung zu empfangen, **dadurch gekennzeichnet, dass**
die Bewegungsmodellerzeugungseinheit (11) ein Bewegungsmodell entsprechend einer für die Bewertung erforderlichen Einstellung erzeugt.

11. Simulationssystem, das eine Bewegung einer Vielzahl von bewegbaren Objekten, einschließlich einer Person und eines autonomen mobilen Roboters in einem Gebäude, das einen Aufzug umfasst, bewertet, wobei das Simulationssystem Folgendes umfasst:
eine Bewegungsmodellerzeugungseinheit (11), die dazu ausgelegt ist, ein Bewegungsmodell zu erzeugen, welches eine mit der Bewegung der Vielzahl von bewegbaren Objekten zusammenhängende Bedingung definiert;
eine Bewegungsnachfrageerzeugungseinheit (12), die dazu ausgelegt ist, eine Bewegungsnachfrage jedes Bewegungsmodells zu berechnen;
eine Überwachungssteuereinheit (13), die dazu ausgelegt ist, die Bewegungsnachfrage jedem Bewegungsmodell zuzuweisen;
eine Routenerzeugungseinheit (14), die dazu ausgelegt ist, eine Bewegungsroute jedes Bewegungsmodells basierend auf der Bewegungsnachfrage jedes Bewegungsmodells zu erzeugen;
eine Bewegungssimulationseinheit (15), die dazu ausgelegt ist, eine Bewegung jedes Bewegungsmodells basierend auf der Bewegungsroute jedes Bewegungsmodells zu simulieren;
eine Aufzugssimulationseinheit (16), die dazu ausgelegt ist, einen Betrieb des Aufzugs zu simulieren; und
eine Ausgabeeinheit, die dazu ausgelegt ist, Simulationsergebnisse der Bewegungssimulationseinheit (15) und der Aufzugssimulationseinheit (16) auszugeben,
**dadurch gekennzeichnet, dass** die Bewegungsmodellerzeugungseinheit (11) ein Bewegungsmodell des autonomen mobilen Roboters erzeugt, welches als einen Parameter enthält, ob ein Mitfahren mit einem anderen bewegbaren Objekt, das den Aufzug betritt, möglich ist.

12. Mobilitätsbetriebsbewertungsverfahren zum Bewerten von Bewegung einer Vielzahl von bewegbaren Objekten, einschließlich einer Person und eines autonomen mobilen Roboters in einem Gebäude, das einen Aufzug umfasst, wobei das Mobilitätsbetriebsbewertungsverfahren Folgendes umfasst:
einen Bewegungsmodellerzeugungsvorgang des Erzeugens eines Bewegungsmodells, welches eine mit der Bewegung der Vielzahl von bewegbaren Objekten zusammenhängende Bedingung definiert;
einen Bewegungsnachfrageerzeugungsvorgang des Berechnens einer Bewegungsnachfrage jedes Bewegungsmodells;
einen Zuweisungsvorgang des Zuweisens der Bewegungsnachfrage zu jedem Bewegungsmodell;
einen Routenerzeugungsvorgang zum Erzeugen einer Bewegungsroute jedes Bewegungsmodells basierend auf der Bewegungsnachfrage jedes Bewegungsmodells;
einen Bewegungssimulationsvorgang des Simulierens von Bewegung jedes Bewegungsmodells basierend auf der Bewegungsroute jedes Bewegungsmodells;
einen Aufzugssimulationsvorgang des Simulierens eines Betriebs des Aufzugs;
einen Bewertungsberechnungsvorgang des Berechnens von mit einer Bewegung der Vielzahl von Bewegungsmodellen in dem Gebäude und dem Betrieb des Aufzugs zusammenhängenden Bewertungswerten anhand von Simulationsergebnissen des Bewegungssimulationsvorgangs und des Aufzugssimulationsvorgangs; und
einen Ausgabevorgang des Ausgebens der durch die Bewertungseinheit (17) berechneten Bewertungswerte,
**dadurch gekennzeichnet, dass** im Bewegungsmodellerzeugungsvorgang ein Bewegungsmodell des autonomen mobilen Roboters erzeugt wird, welches als einen Parameter enthält, ob ein Mitfahren mit einem anderen bewegbaren Objekt, das den Aufzug betritt, möglich ist.

## Revendications

1. Système d'évaluation d'opération de mobilité (1, 2) qui évalue le déplacement d'une pluralité d'objets mobiles incluant une personne et un robot mobile autonome dans un bâtiment incluant un ascenseur, le système d'évaluation d'opération de mobilité (1, 2), comprenant :
une unité de génération de modèle de déplacement (11) configurée pour générer un modèle de déplacement définissant une condition liée au déplacement de la pluralité d'objets mobiles ;
une unité de génération de demande de déplacement (12) configurée pour calculer une demande de déplacement de chaque modèle de déplacement ;
une unité de commande de supervision (13) configurée pour allouer la demande de déplacement à chaque modèle de déplacement ;
une unité de génération d'itinéraire (14) configurée pour générer un itinéraire de déplacement de chaque modèle de déplacement sur la base de la demande de déplacement de chaque modèle de déplacement ;
une unité de simulation de déplacement (15) configurée pour simuler un déplacement de chaque modèle de déplacement sur la base de l'itinéraire de déplacement de chaque modèle de déplacement ;
une unité de simulation d'ascenseur (16) configurée pour simuler un fonctionnement de l'ascenseur ;
une unité d'évaluation (17) configurée pour calculer des valeurs d'évaluation liées au déplacement de la pluralité de modèles de déplacement dans le bâtiment et au fonctionnement de l'ascenseur à partir des résultats de simulation de l'unité de simulation de déplacement (15) et de l'unité de simulation d'ascenseur (16) ; et
une unité de sortie configurée pour délivrer en sortie les valeurs d'évaluation calculées par l'unité d'évaluation (17),
**caractérisé en ce que** l'unité de génération de modèle de déplacement (11) génère un modèle de déplacement du robot mobile autonome qui permet, en tant que paramètre, de savoir s'il est possible de monter avec un autre objet mobile qui emprunte l'ascenseur.

2. Système d'évaluation d'opération de mobilité (1, 2) selon la revendication 1, **caractérisé en ce que** l'unité de génération de modèle de déplacement (11) génère un modèle de déplacement du robot mobile autonome qui contient au moins une direction de déplacement et un rayon de braquage en tant que paramètres.

3. Système d'évaluation d'opération de mobilité (1, 2) selon la revendication 1, **caractérisé en ce que** l'unité de simulation de déplacement (15) inclut au moins un parmi un premier agent de déplacement généré sur la base d'un modèle de déplacement et un second agent généré sur la base d'informations sur la mobilité d'une machine réelle.

4. Système d'évaluation d'opération de mobilité (1, 2) selon la revendication 1, **caractérisé en ce que** l'unité de simulation d'ascenseur (16) inclut au moins un parmi un premier agent d'ascenseur généré sur la base d'un modèle d'ascenseur et un second agent d'ascenseur généré sur la base d'informations d'un ascenseur réel.

5. Système d'évaluation d'opération de mobilité (1, 2) selon la revendication 1, **caractérisé en ce que** l'unité d'évaluation (17) calcule une valeur d'évaluation d'un indice d'évaluation pour évaluer un état d'encombrement dans un espace cible, un état de fonctionnement du robot mobile autonome et un état de fonctionnement de l'ascenseur.

6. Système d'évaluation d'opération de mobilité (1, 2) selon la revendication 5, **caractérisé en ce qu'**au moins un indice d'une densité d'encombrement, d'un débit de circulation, d'une vitesse de marche moyenne et d'un nombre de traversées est utilisé comme indice d'évaluation d'un état d'encombrement dans l'espace cible.

7. Système d'évaluation d'opération de mobilité (1, 2) selon la revendication 5, **caractérisé en ce qu'**au moins un indice d'un débit de fonctionnement d'un robot mobile autonome, d'une vitesse de déplacement moyenne et du nombre de fois qu'un robot mobile autonome et une personne sont mélangés est utilisé comme indice d'évaluation de l'état de fonctionnement du robot mobile autonome.

8. Système d'évaluation d'opération de mobilité (1, 2) selon la revendication 5, **caractérisé en ce qu'**au moins un indice d'un temps de durée d'appel moyen, du nombre d'appuis sur un bouton d'appel, d'un nombre moyen de passagers, d'un temps d'ouverture de porte moyen, et du nombre de personnes en attente est utilisé comme indice d'évaluation de l'état de fonctionnement de l'ascenseur.

9. Système d'évaluation d'opération de mobilité (1, 2) selon la revendication 1, **caractérisé en ce que** l'unité de sortie agence chaque état d'opération sur un axe temporel et affiche une transition d'état d'un changement dans l'affichage conformément à l'état de fonctionnement pour un processus dans lequel le robot mobile autonome et l'ascenseur se déplacent conjointement l'un avec l'autre.

10. Système d'évaluation d'opération de mobilité (1, 2) selon la revendication 1, comprenant en outre :
une unité d'entrée configurée pour recevoir une entrée d'un réglage nécessaire à l'évaluation, **caractérisé en ce que**
l'unité de génération de modèle de déplacement (11) génère un modèle de déplacement conformément à un réglage nécessaire pour l'évaluation.

11. Système de simulation qui simule le déplacement d'une pluralité d'objets mobiles incluant une personne et un robot mobile autonome dans un bâtiment incluant un ascenseur, le système de simulation comprenant :
une unité de génération de modèle de déplacement (11) configurée pour générer un modèle de déplacement définissant une condition liée au déplacement de la pluralité d'objets mobiles ;
une unité de génération de demande de déplacement (12) configurée pour calculer une demande de déplacement de chaque modèle de déplacement ;
une unité de commande de supervision (13) configurée pour allouer la demande de déplacement à chaque modèle de déplacement ;
une unité de génération d'itinéraire (14) configurée pour générer un itinéraire de déplacement de chaque modèle de déplacement sur la base de la demande de déplacement de chaque modèle de déplacement ;
une unité de simulation de déplacement (15) configurée pour simuler un déplacement de chaque modèle de déplacement sur la base de l'itinéraire de déplacement de chaque modèle de déplacement ;
une unité de simulation d'ascenseur (16) configurée pour simuler un fonctionnement de l'ascenseur ; et
une unité de sortie configurée pour délivrer en sortie des résultats de simulation de l'unité de simulation de déplacement (15) et de l'unité de simulation d'ascenseur (16),
**caractérisé en ce que** l'unité de génération de modèle de déplacement (11) génère un modèle de déplacement du robot mobile autonome qui permet, en tant que paramètre, de savoir s'il est possible de monter un autre objet mobile qui monte à bord de l'ascenseur.

12. Procédé d'évaluation d'opération de mobilité pour évaluer le déplacement d'une pluralité d'objets mobiles incluant une personne et un robot mobile autonome dans un bâtiment comprenant un ascenseur, le procédé comprenant :
un processus de génération de modèle de déplacement consistant à générer un modèle de déplacement définissant une condition liée au déplacement de la pluralité d'objets mobiles ;
un processus de génération de demande de déplacement pour calculer une demande de déplacement de chaque modèle de déplacement ;
un processus d'attribution consistant à attribuer la demande de déplacement à chaque modèle de déplacement ;
un processus de génération d'itinéraire consistant à générer un itinéraire de déplacement de chaque modèle de déplacement sur la base de la demande de déplacement de chaque modèle de déplacement ;
un processus de simulation de déplacement consistant à simuler le déplacement de chaque modèle de déplacement sur la base de l'itinéraire de déplacement de chaque modèle de déplacement ;
un processus de simulation d'ascenseur pour simuler un fonctionnement de l'ascenseur ;
un processus de calcul d'évaluation pour calculer des valeurs d'évaluation liées au déplacement de la pluralité de modèles de déplacement dans le bâtiment et au fonctionnement de l'ascenseur à partir de résultats de simulation du processus de simulation de déplacement et du processus de simulation d'ascenseur ; et
un processus de sortie consistant à délivrer en sortie des valeurs d'évaluation calculées dans le processus de calcul d'évaluation,
**caractérisé en ce que**, dans le processus de génération de modèle de déplacement, un modèle de déplacement du robot mobile autonome est généré qui indique, en tant que paramètre, si monter avec un autre objet mobile qui emprunte l'ascenseur est possible.
